(19) Europäisches Patentamt / European Patent Office / Office européen des brevets

(11) **EP 1 774 603 B1**

(12) **EUROPÄISCHE PATENTSCHRIFT**

(45) Veröffentlichungstag und Bekanntmachung des Hinweises auf die Patenterteilung:
**20.03.2013  Patentblatt 2013/12**

(21) Anmeldenummer: **05774389.0**

(22) Anmeldetag: **05.08.2005**

(51) Int Cl.:
*H01L 41/047* (2006.01)   *H01L 41/083* (2006.01)
*H01L 41/297* (2013.01)

(86) Internationale Anmeldenummer:
**PCT/DE2005/001389**

(87) Internationale Veröffentlichungsnummer:
**WO 2006/012891 (09.02.2006 Gazette 2006/06)**

(54) **VIELSCHICHTBAUELEMENT UND VERFAHREN ZU DESSEN HERSTELLUNG**

MULTI-LAYERED COMPONENT AND METHOD FOR THE PRODUCTION THEREOF

DISPOSITIF MULTICOUCHE ET PROCEDE POUR SA PRODUCTION

(84) Benannte Vertragsstaaten:
**DE**

(30) Priorität: **05.08.2004   DE 102004038103**

(43) Veröffentlichungstag der Anmeldung:
**18.04.2007   Patentblatt 2007/16**

(60) Teilanmeldung:
**10179362.8 / 2 256 836**

(73) Patentinhaber: **EPCOS AG**
**81669 München (DE)**

(72) Erfinder:
• **FLORIAN, Heinz**
  **A-8530 Wildbach (AT)**
• **RAGOSSNIG, Sigrid**
  **A-9360 Friesach (AT)**
• **RIEMER, Steffen**
  **A-8564 Krottendorf (AT)**
• **SEDLMAIER, Peter**
  **A-9113 Ruden (AT)**

(74) Vertreter: **Epping - Hermann - Fischer**
**Patentanwaltsgesellschaft mbH**
**Ridlerstrasse 55**
**80339 München (DE)**

(56) Entgegenhaltungen:
**EP-A1- 1 677 370     EP-A1- 1 732 146**
**DE-A1- 3 832 658     DE-A1- 19 946 836**

• **PATENT ABSTRACTS OF JAPAN Bd. 012, Nr. 402 (E-673), 25. Oktober 1988 (1988-10-25) -& JP 63 142875 A (SUMITOMO SPECIAL METALS CO LTD), 15. Juni 1988 (1988-06-15)**
• **PATENT ABSTRACTS OF JAPAN Bd. 016, Nr. 417 (E-1258), 3. September 1992 (1992-09-03) -& JP 04 142085 A (HITACHI METALS LTD), 15. Mai 1992 (1992-05-15)**
• **PATENT ABSTRACTS OF JAPAN Bd. 2002, Nr. 07, 3. Juli 2002 (2002-07-03) -& JP 2002 075774 A (FURUYA KINZOKU:KK), 15. März 2002 (2002-03-15)**
• **PATENT ABSTRACTS OF JAPAN Bd. 1996, Nr. 06, 28. Juni 1996 (1996-06-28) -& JP 08 055753 A (TAIYO YUDEN CO LTD), 27. Februar 1996 (1996-02-27)**
• **PATENT ABSTRACTS OF JAPAN Bd. 2002, Nr. 11, 6. November 2002 (2002-11-06) -& JP 2002 208533 A (MATSUSHITA ELECTRIC IND CO LTD), 26. Juli 2002 (2002-07-26)**
• **PATENT ABSTRACTS OF JAPAN Bd. 2002, Nr. 11, 6. November 2002 (2002-11-06) -& JP 2002 198250 A (KYOCERA CORP), 12. Juli 2002 (2002-07-12)**
• **PATENT ABSTRACTS OF JAPAN Bd. 015, Nr. 195 (E-1069), 20. Mai 1991 (1991-05-20) -& JP 03 052211 A (MATSUSHITA ELECTRIC IND CO LTD), 6. März 1991 (1991-03-06)**

EP 1 774 603 B1

**Beschreibung**

Die vorliegende Erfindung betrifft ein Vielschichtbauelement sowie ein Verfahren zu dessen Herstellung.

Eine Schlüsselrolle für die Applikation von Vielschichtbauelementen umfassend piezo- und ferroelektrische Aktoren spielt die mechanische Eigensteifigkeit des Bauelements.

Aus der WO 99/12865 sind piezokeramische Materialien auf der Basis von Bleizirkonat-Titanat bekannt. Dabei wird beim Bleizirkonat-Titanat mit einer Perowskitstruktur $A^{2+}B^{4+}O_3$ durch partielle Substitution mit ferroelektrisch aktiven Verbindungen eine angestrebte Stabilisierung der Werkstoffe erreicht und gleichzeitig die Verringerung der Sintertemperatur ermöglicht.

Die Druckschrift JP 63 142875 A offenbart einen piezoelektrischen Vielschichtaktor mit einem keramischen Grundkörper und in diesem Grundkörper angeordneten Innenelektroden. Die Innenelektroden, deren Hauptbestandteil Palladium oder Platin ist, weisen jeweils eine Vielzahl an Löchern auf.

Die Druckschrift EP 1 732 146 A1 beschreibt ein piezoelektrisches Vielschichtbauelement mit einem keramischen Grundkörper, der einen Stapel aus piezoelektrischen Schichten und eine Vielzahl an Innenelektroden umfasst. Die Innenelektroden weisen mehrere Löcher auf.

Eine zu lösende Aufgabe besteht darin, ein Vielschichtbauelement anzugeben, welches bei möglichst geringer Spannung einen hohen Auslenkungsweg erreicht.

Die Aufgabe wird hinsichtlich eines Vielschichtbauelements und hinsichtlich der Herstellung eines Vielschichtbauelements durch die Merkmale der jeweiligen unabhängigen Ansprüche gelöst.

Es wird ein Vielschichtbauelement vorgeschlagen, welches unter anderem folgende Merkmale umfasst: einen keramischen Grundkörper und mindestens eine im keramischen Grundkörper angeordnete Innenelektrode, wobei die Innenelektrode mehrere Löcher aufweist.

Ein solches Vielschichtbauelement hat den Vorteil, dass die Steifigkeit der Innenelektrode entgegen einer queraxialen Kontraktion teilweise oder ganz verringert wird und dadurch während einer axialen Auslenkung des Vielschichtbauelements eine quasi störungsfreie queraxiale Querkontraktion der Innenelektrode möglich ist. Mit der Querkontraktion wird gleichzeitig bei gleicher angelegter Spannung ein höherer axialer Auslenkungsweg des Vielschichtbauelements erreicht.

Das Vielschichtbauelement kann vorteilhafterweise dichter gesintert werden, da eine mit mehreren Löchern versehene Innenelektrode einen geringeren mechanischen Widerstand gegenüber der Keramik des Grundkörpers stellt, welche während des Sinterns stets zu schrumpfen bestrebt ist. Eine höhere Sinterdichte wird von verbesserten elektrischen Eigenschaften begleitet, und ist somit von Vorteil. Eine höhere Sinterdichte ermöglicht außerdem auch einen höheren Auslenkungsweg. Bei einem Piezoktor kann dies je nach Anwendung von besonderem Vorteil sein.

Zur Herstellung eines Vielschichtbauelements wird vorgeschlagen, dass keramische Folien bereitgestellt werden, auf die Innenelektrodenmaterial, vorzugsweise in der Form einer Paste, gedruckt wird. Die Folien werden gestapelt, geschnitten oder erst geschnitten und dann gestapelt. Das so erhaltene Vielschichtbauelement wird anschließend gesintert.

Es wird bevorzugt, als Innenelektrodenmaterial eine Silber-Palladium Mischung zu verwenden, wobei vorzugsweise Silber in einem Gewichtsanteil von zwischen 60 und 80% und Palladium in einem Gewichtsanteil von zwischen 20 und 40% vorhanden ist.

Aus dieser Mischung wird eine Paste gebildet, welche auf die zu stapelnde keramische Folien gedruckt wird. Das so erhaltene Bauelement wird bei einer Temperatur zwischen 1120 und 1220°C, vorzugsweise bei 1170°C, gesintert, wobei das Innenelektrodenmaterial während des Sintervorgangs gerade ausreichend erweicht, dass sich eine netzförmige Struktur bildet.

Erfindungsgemäß besteht die Innenelektrode aus einem Material, dessen Mischungsverhältnis derart gewählt ist, dass die Liquidustemperatur der Innenelektrode höher ist, als die Temperatur, bei der das Vielschichtbauelement gesintert wird. Es wird insbesondere bevorzugt, dass ein Innenelektrodenmaterial verwendet wird, dessen Liquidustemperatur sich derart geringfügig von der Sintertemperatur des keramischen Grundkörpers unterscheidet, dass der keramische Grundkörper gesintert wird und gleichzeitig die Innenelektrode mehrere Löcher bildet. Es ergibt sich der Vorteil, dass kleine Löcher in der Innenelektrodenschicht erzeugt werden können. Dabei fällt die elektromagnetische Feldverteilung der Innenelektrode homogener aus, je kleiner die Löcher der Innenelektrode ausgebildet werden.

Im Folgenden wird ein Vielschichtbauelement anhand bevorzugter Ausführungsbeispiele näher erläutert. Dabei zeigt

Figur 1 einen Vielschichtpiezoaktor mit einer Piezokeramikschicht welche an eine mit Löchern versehenen Innenelektrode angrenzt,

Figur 2 eine vergrößerte Darstellung der mit Löchern versehenen Elektrode,

Figur 3 eine zweidimensionale fotographische Abbildung einer mit Löchern versehenen Innenelektrode,

Figur 4 eine Graphik zur Darstellung einer bevorzugten, optimalen Einstellung eines durch die Löcher erzeugten Unterbrechungsgrades-der Innenelektrode, einer auf den Vielschichtpiezoaktor anzulegenden Spannung und eines Auslenkungswegs des Vielschichtpiezoaktors.

Es wird ein Weg aufgezeigt, wie bei gegebener Bauteilgeometrie und vorgegebenem Keramik- und Innenelektrodenmaterial die Steifigkeit des Vielschichtbauelements aktiv variiert werden kann.

Es wurde für Testzwecke, beispielsweise auf einem Kraft- oder Auslenkungsmeßplatz, die Steifigkeit von Vielschichtaktoren gemessen. Der sich aus der Messung ergebende integrale Bauteilsteifigkeitswert wurde dabei eins zu eins der Elastizität der Keramik zugeschrieben. In anderen Worten: ein höherer Steifigkeitswert indizierte eine härtere Keramik, je nachdem, ob die Keramik donatordotiert oder akzeptordotiert wurde. Aus dieser Überlegung heraus wurde vor allem über die Zusammensetzung der Keramik (Keramikrezeptur) versucht, den E-Modul des Vielschichtpiezoaktors und somit die Bauteilsteifigkeit einzustellen.

Allgemein kann aber die Steifigkeit K eines Vielschichtbauelements in einem ersten Schritt über die Formel

$$K = \frac{Y \cdot A}{l}$$

abgeschätzt werden, wobei Y das E-Modul, A die Querschnittsfläche und $l$ die Länge des Vielschichtbauelements oder des aktiven Grundkörpers des Vielschichtbauelements ist.

Im Folgenden wird angenommen, dass das Vielschichtbauelement einen Vielschichtpiezoaktor umfasst, wobei andere Vielschichtbauelemente ebenfalls möglich sind, wie beispielsweise Vielschichtkondensatoren oder andere Keramikumfassende Vielschichtbauelemente.

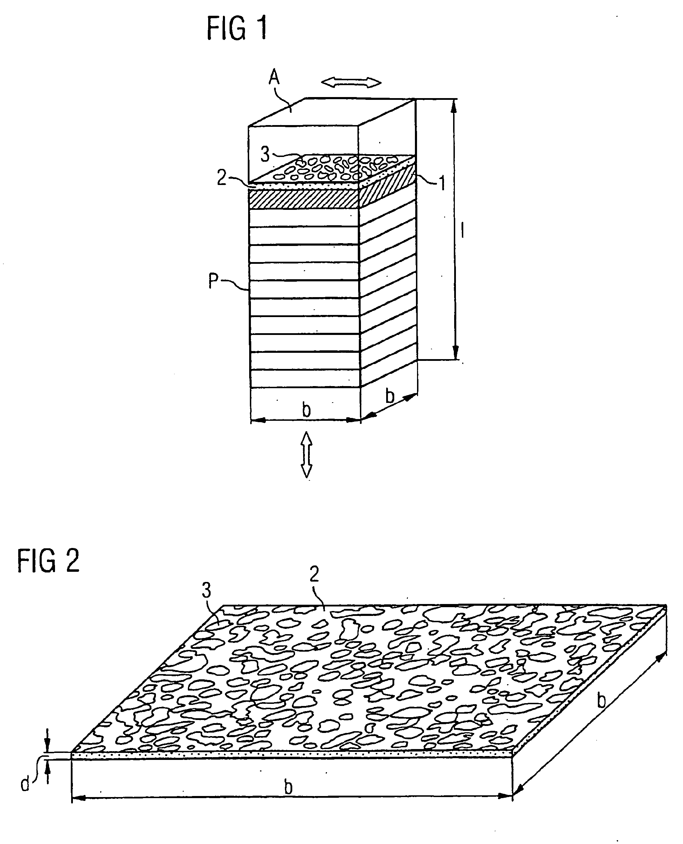

Die Eigensteifigkeit des in Figur 1 gezeigten Vielschichtpiezoaktors P ist direkt proportional zum E-Modul Y und zur Querschnittsfläche A des Vielschichtpiezoaktors P, jedoch indirekt proportional zur Länge $l$ des Vielschichtpiezoaktors ist. Die Querschnittsfläche A und die Länge $l$ sind durch die jeweilige Applikation vorgegeben und somit durch das Anwendungsdesign des Vielschichtpiezoaktors fixiert. Es bleibt daher nur die Variation des E-Moduls Y, um die Bauteilsteifigkeit einzustellen. Dabei handelt es sich um einen integralen E-Modul, welches von dem keramischen Grundkörper bzw. der Anordnung von aufgestapelten Keramikschichten 1 und von der mindestens einen Innenelektrode 2 sowie vom Innenelektrodenverbund mehrerer Innenelektroden 2 abhängig ist. So wird der integrale Bauteil E-Modul Y einerseits durch das Keramikmaterial selbst und andererseits durch das Material und die Geometrie der Innenelektrode 2 bestimmt.

Es ist eine Eigenschaft piezo/ferroelektrischer Materialien, sich bei anliegender elektrischer Spannung auszulenken. Mit der Auslenkung in eine Raumrichtung, beispielsweise die axiale Richtung (unterer Pfeil), geht eine queraxiale Kontraktion (oberer Pfeil) oder Querkontraktion in den Raumrichtungen normal auf die Auslenkungsrichtung einher. Bei Vielschichtpiezoaktoren mit durchgehenden Innenelektroden stehen dieser Querkontraktion die Innenelektroden als mechanischer Gegenspieler entgegen und reduzieren dadurch im Vergleich zu einem monolithischen Keramikquader ohne Innenelektroden die Querkontraktion und damit auch die Auslenkung des Bauteils.

Um also die Querkontraktion zu erleichtern werden erfindungsgemäß die Innenelektroden 2 mit Löchern versehen, wobei es aber nicht erforderlich ist, dass die Löcher die Innenelektrode ganz durchbohren- vorzugsweise können sie auch als erhebliche Einbuchtungen realisiert sein.

Über die beiden Parameter Dicke d der Innenelektroden 2 und des Unterbrechungsgrades 3D, das heißt die Anzahl der Löcher 3 in der Innenelektrode pro Flächeneinheit der Innenelektrode, lassen sich der integrale E-Modul des Vielschichtpiezoaktors und somit seine Steifigkeit bei einer gegebenen Geometrie variieren. Im Profilschliff zeigt sich der Unterbrechungsgrad 3D als elektrodenmaterialfreie Bereiche innerhalb der Innenelektrode. Zur Anpassung der Bauteilsteifigkeit sind also zwei Parameter vorgesehen: die Dicke d der Innenelektrode 2 und der Unterbrechungsgrad 3D der Innenelektrode.

Dabei wird bevorzugt, dass die Dicke der Innenelektroden so gering wie möglich gehalten wird, da hiermit einerseits geringere Mengen an Elektrodenmaterial verwendet werden müssen und somit geringere Kosten anfallen, und andererseits eine höhere Sinterdichte des Vielschichtbauelements erreicht werden kann. Der Vielschichtpiezoaktor ist vorzugsweise so ausgebildet, dass die Innenelektroden mit einer elektrisch leitenden Kontaktschicht verbunden sind um die elektrische Verbindung an eine Spannungs- und Stromquelle herzustellen.

Figur 2 veranschaulicht die Struktur einer erfindungsgemäßen Innenelektrode 2. Die weißen Kreise stellen die Löcher 3 dar. Der Unterbrechungsgrad 3D kann folgendermaßen als Formel ausgedrückt werden:

$$3D = \frac{\sum_{i=1}^{N} AL_i[m^2]}{b^2[m^2]}$$

wobei AL die Fläche eines Lochs oder vorzugsweise die durchschnittliche Fläche eines Lochs (in Quadratmeter), N die Anzahl der Löcher und b die Länge einer Seite der Innenelektrode ist. Der Unterbrechungsgrad wird in Prozent angegeben.

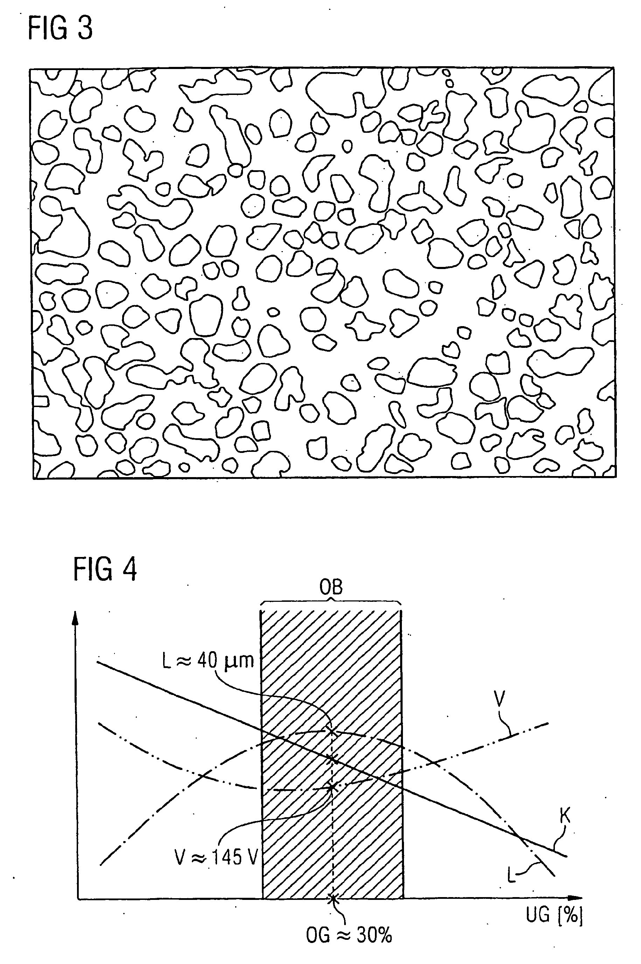

Eine mit Löchern versehene Innenelektrode 2 kann mit einer geeigneten thermischen Prozessführung der maximalen Sintertemperatur in Relation zur Liquidustemperatur des Innenelektrodenmaterials hergestellt werden. Je kleiner die Temperaturdifferenz zwischen der Liquidustemperatur des Innenelektrodenmaterials und der maximalen Sintertemperatur des Vielschichtpiezoaktors eingestellt wird, desto mehr zieht sich die Innenelektrode zusammen, so dass eine durchlöcherte Struktur der Innenelektrode gemäß der Figuren 2 oder 3 während des Sinterns entsteht. Selbstverständlich muss dabei die an sich bekannte Liquidustemperatur des Innenelektrodenmaterials oberhalb der maximalen Sintertemperatur des Vielschichtpiezoaktors liegen, damit die Innenelektrode gerade erweicht, wenn die maximale Sintertemperatur erreicht ist.

Zur Herstellung eines elektrischen Bauelements mit einer mit Löchern versehenen Innenelektrode 2 werden Folien bereitgestellt, die keramisches Material mit piezoelektrischen Eigenschaften, beispielsweise Bleizirkonat-Titanat, enthalten. Es ist jedoch auch piezoelektrisch aktives keramisches Material einsetzbar, das eine andere Zusammensetzung aufweist, wie zum Beispiel eine Mischung aus Bleizirkonat-Titanat und Blei-Nickelniobat sowie ein Material, das kein Blei enthält, wie zum Beispiel Natrium-Kaliumniobat.

Die Folien werden zur Herstellung der Innenelektroden mittels eines Siebdruckverfahrens mit einer Paste bedruckt, die ein Gemisch aus Silber und Palladium in einem Verhältnis von vorzugsweise zwischen 60 und 95 Gew.-% Silber und 5 bis 40 Gew.-% Palladium enthält. Insbesondere führt ein Verhältnis von 70 zu 30 Gewichtsanteilen der jeweiligen Materialien zu besonders guten Ergebnissen. Anhand einer Änderung dieser Gewichtsanteile ist eine Anpassung der für die Herstellung des elektrischen Bauelements erforderlichen Prozesstemperatur möglich, um bei unterschiedlichen keramischen Materialien mit unterschiedlichen Sintertemperaturen die netzförmige Struktur der Innenelektrode 2 zu formen, einzustellen und gleichzeitig eine ausreichende Sinterverdichtung der Keramik zu erreichen.

Die mit der ilber-Palladiumpaste bedruckten Folien werden in der Weise gestapelt und miteinander verpresst, dass ein der Funktion des elektrischen Bauelements entsprechender Stapel entsteht.

Nach dem Ausbrand des in der Folie und in der Metallpaste enthaltenen organischen Bindemittels wird das Bauelement, das die genannten Mischung auch Silber und Palladium als Innenelektrode enthält, auf eine Temperatur von 1170° erwärmt und bei dieser Temperatur zwei Stunden lang gehalten. Diese Temperatur liegt unter der mischungsverhältnisabhängigen Liquidustemperatur der Silber-Palladium Mischung, die für ein Mischungsverhältnis von 70 % Silber und 30 % Palladium bei 1228°C liegt. Dabei wird die Keramik gesintert, wobei sich in der Innenelektrode sich die erwünschte Netzstruktur ausbildet.

Figur 3 zeigt ein REM-Bild einer durch die thermische Prozessführung netzförmig ausgebildete Innenelektrode.

Die beim Sintern zu erwartende Anzahl der Löcher 3 und deren aufsummierte Fläche kann durch Erfahrungswerte aus Testergebnissen ermittelt werden, wobei die Bildung der Löcher von der Temperatur und dem Druck beim Sintern sowie vom Material der Innenelektrode beeinflusst wird.

Figur 4 zeigt qualitativ eine Kurve K, welche die Änderung der Steifigkeit der Innenelektrode in Abhängigkeit des Unterbrechungsgrades UG darstellt. Kurve V zeigt Spannungen, die auf den Vielschichtpiezoaktor angelegt werden, um einen bestimmten Auslenkungsweg L des Vielschichtpiezoaktors zu erreichen. Die Kurve L zeigt unterschiedliche Auslenkungswege, welche mit einer konstanten Spannung erreicht werden. Die Form der Kurven L und V ist zudem vom Unterbrechungsgrad der Innenelektrode bzw. von ihrer Steifigkeit K abhängig. Da die Kurven V, K und L alle unterschiedliche physikalische Größen betreffen, ist die linke Achse der Grafik ohne kennzeichnende Einheit angegeben. Es wird insbesondere bevorzugt, dass die Innenelektrode einen Unterbrechungsgrad innerhalb des in der Figur 4 angegebenen optimalen Bereichs OB aufweist, da hier der tiefste Punkt der Kurve V, also eine niedrige Spannung, den höchsten Punkt der Kurve L, also einen hohen Auslenkungsweg, entspricht. Es hat sich ergeben, dass ein Unterbrechungsgrad UG von ca. 30% (qualitativ auf der untersten horizontalen Achse mit einem x markiert) geeignet ist, um einen maximalen Auslenkungsweg von 40 $\mu$m des Vielschichtpiezoaktors bei einer minimalen Spannung von 145 V zu erreichen.

Es wird bevorzugt, dass die Durchmesser der kreisförmigen Löcher der Innenelektrode bei 10$\mu$m bis 15$\mu$m liegen und/oder die Flächen von nichtkreisförmigen Löchern bei ca. 50 bis 90 $\mu$m$^2$ liegen. Diese relativ geringen Größen verhindern, dass sich an den Löchern unerwünschte und störende elektrische Felder bilden. Mit dieser Maßnahme kann das elektrische Feld über der gesamten Innenelektrode als homogen betrachtet werden. Für derart kleine Löcher ist es daher vorteilhaft, die Löcher während des Sinterns nach dem erfindungsgemäßen Herstellungsverfahren auszubilden, da per Siebdruckverfahren derart kleine Löcher schwer zu realisieren sind.

Die Sinterdichte des keramischen Grundkörpers, bzw. dessen Dielektrikums- oder Keramikschichten hängt mit der geometrischen Struktur der Innenelektrode zusammen. Sind die Innenelektroden durchgängig, stellen diese einen größeren Widerstand gegenüber dem Bestreben des keramischen Grundkörpers während des Sinterns zu schrumpfen entgegen. Mit Löchern versehene Innenelektroden erlauben in Gegensatz dazu die Herstellung von Vielschichtbauelementen mit tendenziell höheren Sinterdichten, da die Innenelektroden einen geringeren Widerstand gegenüber dem Schrumpfen des keramischen Grundkörpers entgegenstellen. Höhere Sinterdichten haben den Vorteil, dass ein größeres Kornwachstum begleitet von Poreneliminierung, bzw. Reduzierung freier Kornoberflächen des keramischen Materials ermöglicht wird, wobei im Allgemeinen eine Verringerung der Oberflächen- und Korngrenzenenergie angestrebt wird, die zu einer Erniedrigung der gesamten freien Enthalpie des Sinterkörpers führt. Die elektrischen Eigenschaften des gesinterten Vielschichtpiezoaktors werden somit verbessert, da beispielsweise eine homogenere elektromagnetische Feldverteilung und ein einfacheres und voraussehbares Auslenkungsverhalten des Vielschichtpiezoaktors gewährleistet wird. Eine höhere Sinterdichte ist daher auch nicht nur für Vielschichtpiezoaktoren, sondern beispielsweise auch für Vielschichtkondensatoren, von besonderem Interesse.

Bezugszeichenliste

1    keramische Schicht
2    Innenelektrode
3    Loch einer Innenelektrode

A    Querschnittsfläche eines Piezoaktors
l    änge des Piezoaktors
b    Länge einer Seite einer Innenelektrode
P    Piezoaktor

**Patentansprüche**

1.  Vielschichtbauelement (P), umfassend:

    - einen keramischen Grundkörper,
    - mindestens eine im keramischen Grundkörper angeordnete Innenelektrode (2), die mehrere Löcher aufweist,

    **dadurch gekennzeichnet dass** die Innenelektrode aus einem Material besteht, dessen Mischungsverhältnis derart gewählt ist, dass die Liquidustemperatur der Innenelektrode höher ist, als die Temperatur, bei der das Vielschichtbauelement gesintert wird,

    - wobei die Innenelektrode (2) eine Silber-Palladium Mischung enthält und
    - wobei das Vielschichtbauelement (P) bei einer Temperatur zwischen 1120 und 1220°C gesintert ist.

2.  Vielschichtbauelement nach Anspruch 1, bei dem die Innenelektrode (2) mit einer Querkontraktion des Vielschichtbauelements dehnbar ist.

3.  Vielschichtbauelement nach einem der Ansprüche 1 oder 2, bei dem die Löcher (3) der zumindest einen Innenelektrode (2) als Einbuchtungen der Innenelektrode realisiert sind.

4.  Vielschichtbauelement nach einem der vorhergehenden Ansprüche, bei dem die Löcher (3) einen Durchmesser zwischen 10 und 15 μm aufweisen.

5.  Vielschichtbauelement nach einem der vorhergehenden Ansprüche, bei dem das Verhältnis der Fläche der Löcher (3) zur Fläche der Innenelektrode (2) bei 30% liegt.

6.  Vielschichtbauelement nach einem der vorhergehenden Ansprüche, bei dem die Innenelektrode (2) eine Silber-Palladium Mischung enthält, wobei Silber in einem Gewichtsanteil von 60 bis 95% und Palladium in einem Gewichtsanteil von 5 bis 40% vorhanden ist.

7.  Vielschichtbauelement nach einem der vorhergehenden Ansprüche, bei dem das Vielschichtbauelement (P) ein Vielschichtpiezoaktor ist.

8.  Vielschichtbauelement nach einem der vohergehenden Ansprüche, bei der der keramische Grundkörper gewählt aus einem der Materialien: Bleizirkonat-Titanat, Blei-Nickelniobat, Natrium-Kaliumniobat.

9.  Verfahren zur Herstellung eines Vielschichtbauelements (P) mit zumindest einer Innenelektrode (2) in einem keramischen Grundkörper,

    - bei dem für die Innenelektrode ein Material verwendet wird, dessen Mischungsverhältnis derart gewählt ist, dass die Liquidustemperatur der Innenelektrode höher ist, als die Temperatur, bei der das Vielschichtbauelement gesintert wird,
    - wobei die Innenelektrode (2) eine Silber-Palladium Mischung enthält und
    - wobei das Vielschichtbauelement (P) bei einer Temperatur zwischen 1120 und 1220°C gesintert wird.

10. Verfahren nach Anspruch 9, bei dem als Innenelektrodenmaterial eine Silber-Palladium Mischung verwendet wird, wobei Silber in einem Gewichtsanteil von 60 bis 80% und Palladium in einem Gewichtsanteil von 20 bis 40% vorhanden ist.

11. Verfahren nach einem der Ansprüche 9 oder 10, bei dem als Vielschichtbauelement (P) ein Vielschichtpiezoaktor gebildet wird.

**Claims**

1.  Multi-layered component (P), comprising:

    - a ceramic base body,
    - at least one internal electrode (2) which is arranged in the ceramic base body and has a plurality of holes,

**characterized in that** the internal electrode consists of a material with a mixing ratio which is selected in such a manner that the liquidus temperature of the internal electrode is higher than the temperature at which the multi-layered component is sintered,

- wherein the internal electrode (2) contains a silver-palladium mixture, and
- wherein the multi-layered component (P) is sintered at a temperature of between 1120 and 1220°C.

2. Multi-layered component according to Claim 1, wherein the internal electrode (2) is flexible during a transverse contraction of the multi-layered component.

3. Multi-layered component according to either of Claims 1 and 2, wherein the holes (3) in the at least one internal electrode (2) are realized in the form of indentations in the internal electrode.

4. Multi-layered component according to one of the preceding claims, wherein the holes (3) have a diameter of between 10 and 15 $\mu$m.

5. Multi-layered component according to one of the preceding claims, wherein the ratio of the surface area of the holes (3) to the surface area of the internal electrode (2) is 30%.

6. Multi-layered component according to one of the preceding claims, wherein the internal electrode (2) contains a silver-palladium mixture, silver being present in a proportion of 60 to 95% by weight and palladium being present in a proportion of 5 to 40% by weight.

7. Multi-layered component according to one of the preceding claims, wherein the multi-layered component (P) is a multi-layered piezoelectric actuator.

8. Multi-layered component according to one of the preceding claims, wherein the ceramic base body is selected from one of the following materials: lead zirconate titanate, lead nickel niobate, sodium potassium niobate.

9. Method for producing a multi-layered component (P) comprising at least one internal electrode (2) in a ceramic base body,

- wherein, for the internal electrode, use is made of a material with a mixing ratio which is selected in such a manner that the liquidus temperature of the internal electrode is higher than the temperature at which the multi-layered component is sintered,
- wherein the internal electrode (2) contains a silver-palladium mixture, and
- wherein the multi-layered component (P) is sintered at a temperature of between 1120 and 1220°C.

10. Method according to Claim 9, wherein the internal electrode material used is a silver-palladium mixture, silver being present in a proportion of 60 to 80% by weight and palladium being present in a proportion of 20 to 40% by weight.

11. Method according to either of Claims 9 and 10, wherein a multi-layered piezoelectric actuator is formed as the multi-layered component (P).

## Revendications

1. Élément multicouche (P), comprenant :

- un corps de base en céramique ;
- au moins une électrode intérieure (2) disposée dans le corps de base en céramique comportant plusieurs trous ;

**caractérisé en ce que** l'électrode intérieure se compose d'un matériau dont le rapport de mélange est sélectionné de telle sorte que la température de liquidus de l'électrode intérieure est supérieure à la température à laquelle l'élément multicouche est fritté ;

- l'électrode intérieure (2) contenant un mélange argent-palladium ;
- l'élément multicouche (P) étant fritté à une température comprise entre 1120 et 1220 °C.

2. Élément multicouche selon la revendication 1, dans lequel l'électrode intérieure (2) peut être étirée par contraction transversale de l'élément multicouche.

3. Élément multicouche selon l'une quelconque des revendications 1 ou 2, dans lequel les trous (3) de l'au moins une électrode intérieure (2) prennent la forme d'anfractuosités de l'électrode intérieure.

4. Élément multicouche selon l'une quelconque des revendications précédentes, dans lequel les trous (3) présentent un diamètre compris entre 10 et 15 $\mu$m.

5. Élément multicouche selon l'une quelconque des revendications précédentes, dans lequel le rapport de l'aire des trous (3) par rapport à l'aire de l'électrode intérieure (2) est de 30 %.

**6.** Élément multicouche selon l'une quelconque des revendications précédentes, dans lequel l'électrode intérieure (2) contient un mélange argent-palladium, l'argent présentant un rapport pondéral de 60 à 95 % et le palladium présentant un rapport pondéral de 5 à 40 %.

**7.** Élément multicouche selon l'une quelconque des revendications précédentes, dans lequel l'élément multicouche (P) est un actionneur piézoélectrique multicouche.

**8.** Élément multicouche selon l'une quelconque des revendications précédentes, dans lequel le corps de base en céramique est sélectionné parmi un des matériaux suivants : titano-zirconate de plomb, niobate plomb-nickel, niobate sodium-hydroxyde de potassium.

**9.** Procédé de fabrication d'un élément multicouche (P) pourvu d'au moins une électrode intérieure (2) placée dans un corps de base en céramique ;

  - dans lequel le matériau utilisé pour l'électrode intérieure présente un rapport de mélange sélectionné de telle sorte que la température de liquidus de l'électrode intérieure est supérieure à la température à laquelle l'élément multicouche est fritté ;
  - l'électrode intérieure (2) contenant un mélange argent-palladium ; et
  - l'élément multicouche (P) étant fritté à une température comprise entre 1120 et 1220 °C.

**10.** Procédé selon la revendication 9, dans lequel le matériau utilisé pour les électrodes intérieures est un mélange argent-palladium, l'argent présentant un rapport pondéral de 60 à 80 % et le palladium présentant un rapport pondéral de 20 à 40 %.

**11.** Procédé selon l'une quelconque des revendications 9 ou 10, dans lequel l'élément multicouche (P) utilisé est un actionneur piézoélectrique multicouche.

## FIG 1

## FIG 2

## FIG 3

## FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9912865 A
- JP 63142875 A
- EP 1732146 A1